# EUROPEAN PATENT APPLICATION

(11) **EP 1 616 898 A1**
(43) Date of publication of application: **18.01.2006**
(21) Application number: 05254338.6
(22) Date of filing: 11.07.2005
(51) Int. Cl.: C08G 73/10, C09D 179/08

(54) **Polyamic acids, polyimide films and polyimide-metal laminates and methods for making same**

(30) Priority: 09.07.2004 JP 2004203290
(71) Applicant: DuPont-Toray Company, Ltd., Chuo-ku Tokyo 103 (JP)
(72) Inventor: Uhara, Kenji, 102 Toray Matsuzono Apartment 19, Nagoya (JP)
(74) Representative: Towler, Philip Dean

(57) **Abstract**

A polyamic acid obtained by the reaction of an aromatic diamine containing 1-100 mol percent of a carboxy-4,4'-diaminobiphenyl and an aromatic tetracarboxylic dianhydride or derivative thereof is provided. A polyimide is obtained from the imidization of the polyamic acid. Methods for obtaining the polyamic acid, the polyimide, a polyimide film, and a polyimide film-metal laminate are also disclosed. The polyimide film-metal laminate has a high peel strength of at least 10N/cm when laminated to a metal foil using an adhesive, and as such can generally be used as a flexible circuit substrate.

## Description

### FIELD OF THE INVENTION

The present invention relates generally to polyamic acids and polyimides made therefrom, and methods for making same, and, more specifically, to polyimide films used as a base substrate for electronic circuits.

### BACKGROUND INFORMATION

Polyimide films have been widely used as base films for flexible circuit substrates. Oftentimes, these films are laminated with a metal foil, for example, a copper foil, and are used primarily for their superior electrical insulation properties and heat resistance.

However polyimide films, in many cases, may not have sufficient peel strength (even when an adhesive is used) and can sometimes peel away from the metal causing a long-term reliability problem. To improve this drawback, various electrical, physical, or chemical treatments have been attempted to improve the surface of the polyimide. But, those treatments can also have problems such as using caustic (or very acidic) reagents, adding processing time, and increasing labor requirements.

As a method for improving the adhesive strength of a polyimide film, for example, plasma processing of the film's surface (as in Japanese Kokai Patent No. Hei 8[1996]-41227) is known. But in this case, the problem remains that extra processing steps are required to employ the plasma treatment process.

In addition, coating polyimide films with a silane coupling agent (as in Japanese Kokai Patent No. Hei 6[1994]-336533) is also known. But in this case there are problems, such as by adding a silane coupling agent, the adhesive strength is sometimes lowered because the silane coupling agent can decompose during subsequent heat treatment steps used to convert the polyamic acid to a polyimide.

Furthermore, polyimide films containing tin compounds, and having an excellent adhesion property (as in Japanese Kokai Patent No. Hei 4[1992]-261466) are also known. But, the peel strength of these polyimide films can be about 10 N/cm or less, none having good adhesion force.

Finally, thermoplastic polyimides having good adhesion properties (as in Japanese Kokai Patent No. 2003-27014) are known, but can have a drawback in that these polyimides can 'sink' during soldering due to the polyimide's thermoplasticity.

As such, there remains a need for polyimide films in general (and methods for making same) to have sufficient peel strength when adhered to a metal substrate using an adhesive, in that this may be achieved at low cost without requiring many reagents, time, labor, and the like to be used.

### SUMMARY OF THE INVENTION

In one embodiment, a method for the preparation of a polyamic acid includes reacting at least one aromatic diamine containing 1-100 mol percent of carboxy-4,4'-diaminobiphenyl of Formula 1 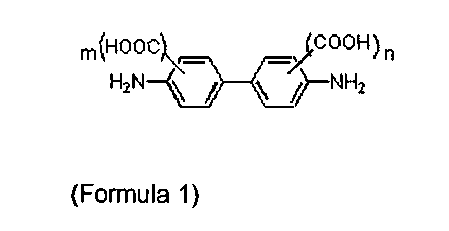
wherein m and n represent integers of 4 or less, including 0, and (m+n) is an integer of 1 or greater; and at least one aromatic tetracarboxylic dianhydride or a derivative thereof.

In another embodiment, the carboxy-4,4'-diaminobiphenyl mentioned above can be either 2,6'-dicarboxy-4,4'-diaminobiphenyl or 3,3'-dicarboxy-4,4'-diaminobiphenyl (or a combination of the two) represented respectively by Formula 2 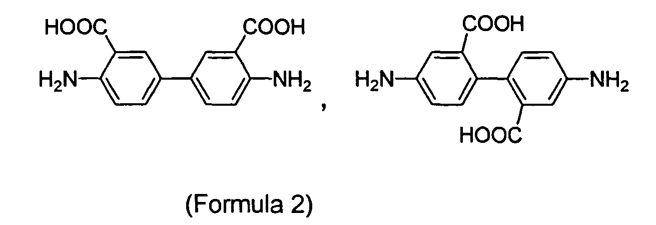 and can be reacted with at least one aromatic tetracarboxylic dianhydride or a derivative thereof, to form a polyamic acid.

In another embodiment, a polyimide is obtained from the imidization reaction of the above-mentioned polyamic acids. The polyimide may be thermally or chemically imidized.

In another embodiment, a copolyimide is obtained from two polyamic acids, the copolyimide having both the structural units of Formulas 3 and 4, 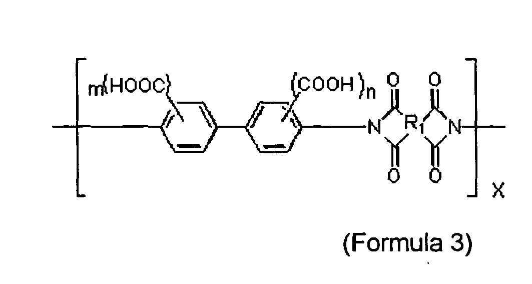 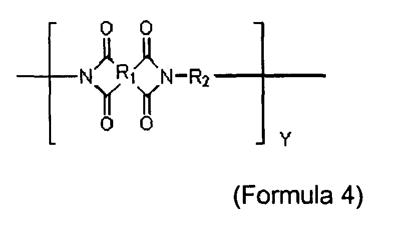
wherein R₁ represents a group expressed by the following general Formula 5, 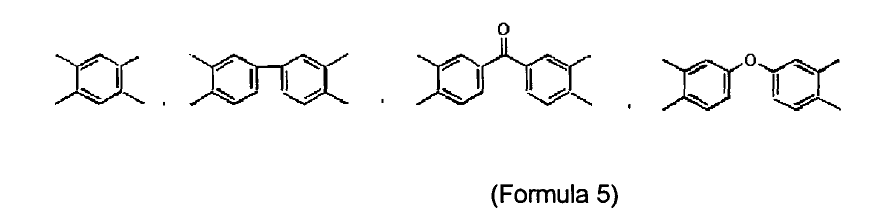
and wherein R₂ represents a group expressed by the following general Formula 6, 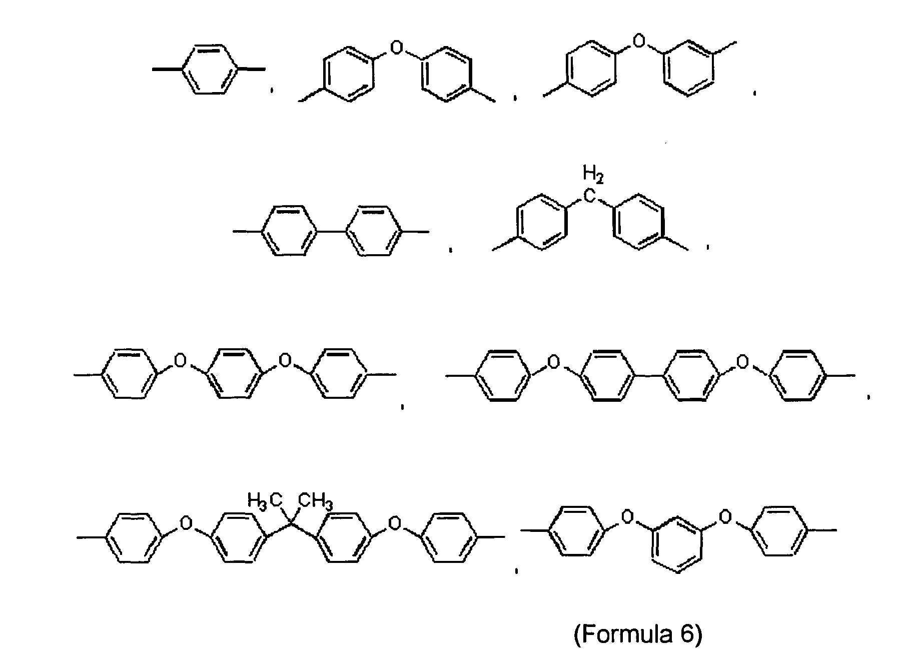
and wherein the molar ratio of X:Y ranges from about 1:99 to about 100:0.

In yet another embodiment, a method for obtaining a polyimide film includes forming a polyamic acid solution comprising: a polyamic acid prepared by reacting a mixture comprising at least one aromatic diamine containing 1-100 mol percent of carboxy-4,4'-diaminobiphenyl of Formula 1 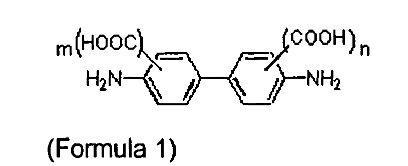
wherein m and n represent integers of 4 or less, including 0, and (m+n) is an integer of 1 or greater; with at least one aromatic tetracarboxylic dianhydride or a derivative thereof, and, a solvent; casting the polyamic acid solution as a film; and imidizing the polyamic acid solution to form a polyimide film. The polyimide film may be bonded to a copper foil with an adhesive, the polyimide film and metal forming a laminate where the laminate exhibits a peel strength of at least 10N/cm, the laminate being useful to make a flexible circuit substrate.

### DETAILED DESCRIPTION OF THE PREFERRED EMBODIMENT(S)

A method for the preparation of a polyamic acid from a diamine component and a dianhydride component, which comprises the step of: reacting at least one diamine, present in an amount of a least 1-100 mol percent of the total diamine component, of carboxy-4,4'-diaminobiphenyl of Formula 1 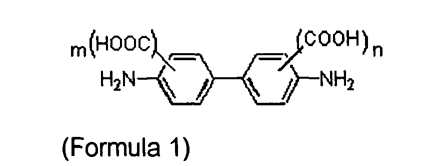
wherein m and n represent integers of 4 or less, including 0, and (m+n) is an integer of 1 or greater; and at least one aromatic tetracarboxylic dianhydride or a derivative thereof. The total diamine component may additionally comprise at least one aromatic diamine selected from the group consisting of: p-phenylene diamine, m-phenylene diamine, penthidine, p-xylylene diamine, 4,4'-diaminodiphenyl ether, 3,4'-diaminodiphenyl ether, 4,4' diaminodi-phenylmethane, 4,4'-diaminodiphenylsulfone, 3,3'-dimethoxypenthidine, 1,4-bis(3-methyl-5-aminophenyl)benzene, amide-forming derivatives thereof, and mixtures thereof. The carboxy-4,4'-diaminobiphenyl may be selected from the group consisting of 2,6'-dicarboxy-4,4'-diaminobiphenyl and 3,3'-dicarboxy-4,4'-diaminobiphenyl. More specifically, one embodiment may contain 5-100 mol percent of the carboxy-4,4'-diaminobiphenyl represented by Formula 1.

At least one aromatic tetracarboxylic dianhydride can be derived from an aromatic tetracarboxylic acid, the acid being selected from the group comprising pyromellitic acid, 3,3',4,4'-biphenyltetracarboxylic acid, 2,3',4,4'-biphenyltetracarboxylic acid, 3,3',4,4'-benzophenone tetracarboxylic acid, 2,3,6,7-naphthalene dicarboxylic acid, 2,2-bis(3,4-dicarboxyphenyl) ether, pyridine-2,3,5,6-tetracarboxylic acid, amide-forming derivatives thereof, and mixtures thereof. These acids can be used to derive their corresponding dianhydrides, these dianhydrides making up some, if not all, of the dianhydride component of the present invention.

The step of reacting the diamine component with the dianhydride component may occur in a solution comprising a solvent selected from the group consisting of sulfoxides, formamides, acetamides, pyrrolidones, phenols, aprotic polar solvents, aromatic hydrocarbons, and mixtures thereof.

In one embodiment of the present invention, a polyamic acid is obtained by the chemical reaction of at least one aromatic diamine containing 1-100 mol percent (of the total diamine component) of carboxy-4,4'-diaminobiphenyl represented by Formula 1 below, 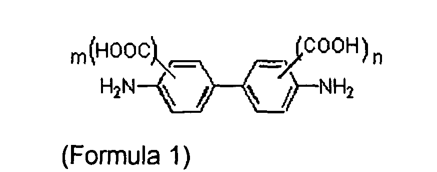
wherein m and n represent integers of 4 or less, including 0, and (m+n) is an integer of 1 or greater; with at least one aromatic tetracarboxylic dianhydride or a derivative thereof.

A copolyimide in accordance with the present invention is obtained from the imidization reaction of at least some of the above mentioned polyamic acid with optionally other, more generic polyamic acids. The polyimide may be thermally or chemically imidized. In one embodiment, a copolyimide is obtained having both the structural units of formula 3 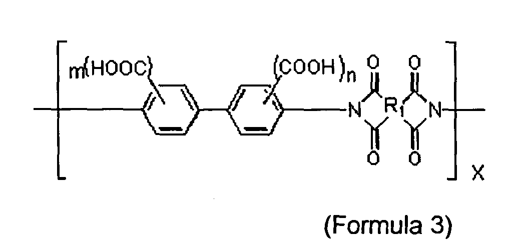 and of Formula 4 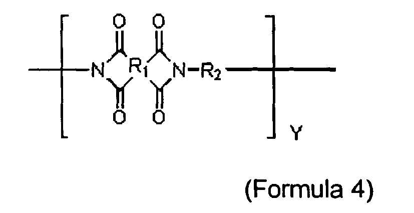
wherein R₁ represents a group expressed by the following general Formula 5. 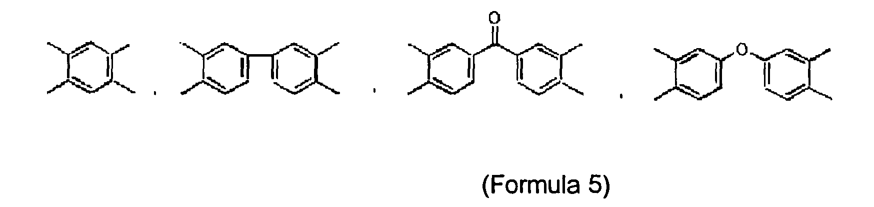
and wherein R₂ represents a group expressed by the following general formula 6, 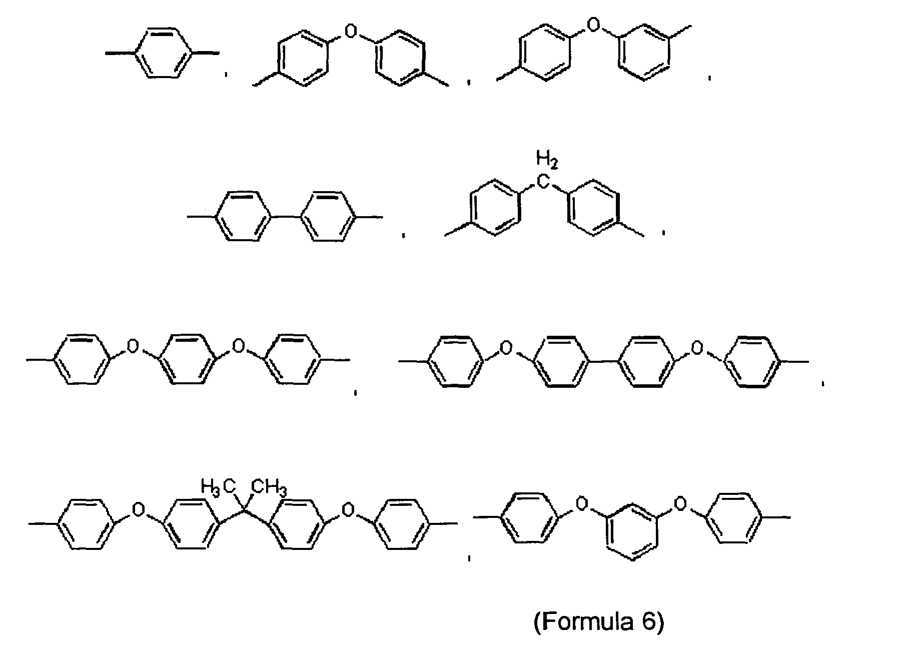 and wherein the mole ratio of X:Y is 1:99 to about 100:0.

In accordance with the present invention, a method for obtaining a polyimide film comprises the steps of: providing a polyamic acid solution comprising: a polyamic acid prepared by reacting a mixture comprising at least one aromatic diamine containing 1-100 mol percent of carboxy-4,4'-diaminobiphenyl of Formula 1 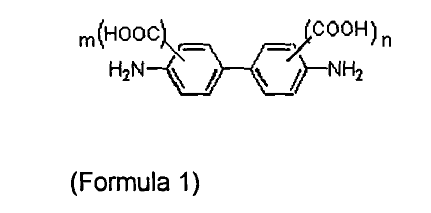
wherein m and n represent integers of 4 or less, including 0, and (m+n) is an integer of 1 or greater; with at least one aromatic tetracarboxylic dianhydride or a derivative thereof, and, a solvent; casting the polyamic acid solution as a film; and imidizing the polyamic acid solution to form a polyimide film. The polyimide film may then be bonded to a copper foil with an adhesive to form a laminate where the laminate exhibits a peel strength of at least 10N/cm.

In another embodiment, a flexible circuit substrate may be obtained by press bonding a metal foil to the polyimide film mentioned above using an adhesive.

A polyamic acid in accordance with the present invention is typically synthesized from an aromatic diamine containing 1-100 mol percent of carboxy-4,4'-diaminobiphenyl expressed by the general formula (I) shown below and an aromatic tetracarboxylic dianhydride or its derivative.

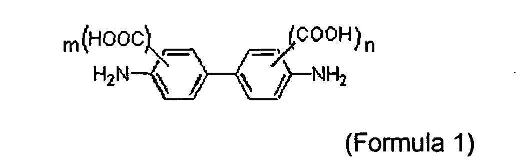

In Formula 1, m and n represent integers of 4 or less, including 0, and (m+n) represents an integer of 1 or greater. In one embodiment of the present invention, the aforementioned carboxy-4,4'-diaminobiphenyl can be 2,6'-dicarboxy-4,4'-diaminobiphenyl, 3,3'-dicarboxy-4,4'-diaminobiphenyl, or a combination of the two, these monomers expressed by general formula (2) shown below,

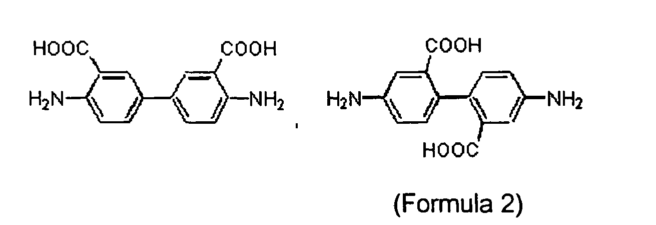

In one embodiment of the present invention, the polyimide film (or copolyimide film) can be bonded to copper foil by thermo-compression using an adhesive to form a laminate. In these cases, the laminate can have a peel strength, measured by method herein disclosed, of greater than 10 N/cm. Peel strength is the strength required to pull a polyimide film (or copolyimide film) from a copper foil (thickness 35 µm, BAC-13-T, Japan Energy Co.) when these two materials are bonded together using a thermo-compression method operated at about 180°C and 4.4 x 10⁷ Pa pressure for about 60 minutes using Pyralux® R, LF-0100, du Pont de Nemours & Co. adhesive film. Other more detailed aspects of this method can be found in published laboratory methods like JIS C5016-1994.

In one embodiment of the present invention, the production method for the polyimide film (and copolyimide film) includes synthesis by thermally and/or chemically imidizing any one of the aforementioned polyamic acids. Moreover, a flexible circuit substrate, in accordance with the present invention, can be obtained by press bonding a metal foil to the aforementioned polyimide film using an adhesive to form a laminate. Typically, the polyimide film-metal laminates of the present invention can have a high peel strength of 10 N/cm or greater. In addition, these laminates can show good (i.e. low) dimensional stability over long periods of time, ranging temperatures, and ranging conditions. As such, these laminates can be useful a substrate for a flexible circuit having good long-term reliability in the circuitry market.

The peel strength of these laminates can be further enhanced by a plasma treatment, electrical treatment (such as corona treatment), physical treatment, or chemical treatment, if necessary (or all, or any combination of the above). In the present invention however, the peel strength shown are values measured before any of these enhancements are performed. As such, these value accurately reflect the essential improvement of peel strength of the polyimide films of the present invention.

In one embodiment of the present invention, the amount of carboxy-4,4'-diaminobiphenyl present in the polyamic acid can be adjusted to include the range of about 5-100 mol%.

In another embodiment of the present invention, the carboxyl groups of the aforementioned carboxy-4,4'-diaminobiphenyl may have multiple substitution groups. Moreover, the substitution of the carboxyl groups may result in the monomer thus being 2,6'-dicarboxy-4,4'-diaminobiphenyl, 3,3'-dicarboxy-4,4'-diaminobiphenyl, and 2,3'-dicarboxy-4,4'-diaminobiphenyl. For simplicities purpose, 2,6'-dicarboxy-4,4'-diaminobiphenyl and/or 3,3'-dicarboxy-4,4'-diaminobiphenyl is generally preferred as these monomers are readily available commercially.

In another embodiment of the present invention, examples of useful organic solvents to be used for the formation of polyamic acid solutions (which are the precursors of polyimide films in the present invention) include, but are not limited to, sulfoxide solvents such as dimethyl sulfoxide, diethyl sulfoxide, etc., formamide solvents such as N,N-dimethyl formamide, N,N-diethyl formamide, etc., acetamide solvents such as N,N-dimethyl acetamide, N,N-diethyl acetamide, etc., pyrrolidone solvents such as N-methyl-2-pyrrolidone, N-vinyl-2-pyrrolidone, etc., phenol solvents such as phenol, o-, m-, or p-cresol, xylenol, halogenated phenol, catechol, etc., or aprotic polar solvents such as hexamethylphosphoramide, γ-butyrolactone, etc. These solvents may be used alone or as mixtures of one or more of the above. In addition, aromatic hydrocarbons such as xylene, toluene, etc., can be used. In one embodiment, the organic solvent used to polymerize 2,6'-dicarboxy-4,4'-diaminophenyl with the dianhydride component is N-methyl-2-pyrrolidone.

In one embodiment of the present invention, the solids content of the polyamic acid in the organic solvent (i.e. the polyamic acid solutions) can be between 5-40 wt%, sometimes 10-30 wt%. In addition, the viscosity the polyamic solution can be in the range of 10-2,000 Pa·s as measured by a Brookfield viscometer, or can be in the range of 100-1,000 Pa·s. Finally, the polyamic acid solutions of the present invention can be partially imidized.

In the present invention, the dianhydride component and diamines component (as constituents of a polyamic acids) are typically polymerized in an almost equimolar amount. However, one component can be added in excess amount, within about 10 mol percent with respect to the other component if desired. In another embodiment, these two components can be mixed in excess (with respect to each other) in an amount within the range of 5 mol percent.

In one embodiment of the present invention, the polymerization reaction (i.e. the chemical reaction forming the polyamic acid) is carried out the in the temperature range of about 0-80°C for about 10 minutes to about 30 hours under mechanic stirring (and/or mixing) in the presence of an organic solvent. If necessary however, the polymerization reaction may be performed in increments where the temperature may be raised or lowered in any one of a variety of manners.

Generally, there are no specific restrictions on the addition order of dianhydride and diamine components, however if one embodiment the dianhydride component is added to a solution containing the diamine component. Generally speaking, deaeration during the polymerization reaction is an effective method for the preparation of high-quality organic solvent solutions containing polyamic acids. In addition, the polymerization reaction may be controlled by adding a small amount of a terminal blocking agent to the diamine component prior to the polymerization reaction.

In one embodiment of the present invention, a polyamic acid solution is prepared having a viscosity, measured at 25°C by a rotary viscometer, of about 10-500 Pa·s.

The aforementioned polyamic acid solution is cast on a support to obtain a self-supporting polyamic acid film (with optional heat added to dry some of the solvent). Next, the self-supporting polyamic acid film is physically fixed (along the sides) and heat treated at about 200°C to 400°C to form a polyimide.

As herein defined, a "support" means that which has a plane such as glass, metal polymer film, and the like, and that can support the cast polyamic acid when said polyamic acid is cast thereon.

As herein defined, "casting" means that a polyamic acid is spread out on the support. In one instance, a polyamic acid solution is extruded using a bar coater, spin coater, or a pipe-form substance (in an appropriate hollow form) whereby the polyamic acid solution is spread out onto the support.

In the manufacture of the polyimide films (and copolyimide films) of the present invention, the polyimide thus obtained is formed by an imidization-ring closing reaction of the polyamic acid, a chemical ring-closing method by dehydration using (optionally) a dehydration agent and catalyst. When using only heat, a thermal ring-closing method can be employed whereby the dehydration, or a ring closing reaction, is accelerated using only heat.

In the chemical conversion method, a dehydration agent can be an aliphatic acid anhydride such as acetic anhydride (or an acid anhydride such as phthalic anhydride). Other catalysts include, but are not limited to, heterocyclic tertiary amines such as pyridine, picoline, quinoline, and the like, aliphatic tertiary amines such as triethylamine and the like, and tertiary amines such as N,N-dimethylaniline and the like. These can be used alone or in combination with one another.

In one embodiment of the present invention, the polyimide film (and copolyimide film) can have a thickness of about 3-250 µm. If the thickness is less than 3 µm, it can be difficult to maintain the shape of the film. If the thickness exceeds 250 µm, the film can be deficient in bendability and may, in some cases, be unfit for use as a flexible circuit substrate.

Both stretched and unstretched polyimide films can be used in accordance with the present invention. Furthermore, the films of the present invention may contain addition fillers at a weight percent loading of about 10 weight percent or less wherein the filler comprises either an inorganic or organic additives used to improve the processability of the material.

### EXAMPLES

Hereinafter, the present invention is explained more concretely by the following examples. The peel strength in the Examples was measured by the following method.

### Peel strength

This is the strength required when a polyimide film and copper foil (thickness 35 µm, BAC-13-T, Japan Energy Co.) are bonded by thermo-compression at 180°C and 4.4 x 10⁷ Pa pressure for 60 minutes using Pyralux® R LF-0100, E.I. du Pont de Nemours & Co. adhesive film; the resulting laminate is peeled off by the method described in JIS C5016-1994.

### Example 1

In a 300-ml separatory flask provided with DC stirrer, 3,3'-dicarboxy-4,4'-diaminobiphenyl at 1.85 g (6.8 mmol), 4,4'-diaminodiphenyl ether at 18.23 g (90 mmol), and N,N'-dimethyl acetamide at 148.82 g were put and stirred in a nitrogen atmosphere at room temperature. Furthermore, pyromellitic dianhydride at 20.52 g (94 mmol) was divided and added several times over 30 minutes to 1 hour. After stirring for 1 hour, 11.21 g of an N,N'-dimethyl acetamide solution (6 wt%) of pyromellitic dianhydride was dropped over 30 minutes and further stirred for 1 hour.

The polyamic acid thus obtained, weighing about 100.00 g, was deaerated for 5 minutes using hybrid mixer of the Kiens Co. A part of the polyamic acid mixture was taken up on a polyester film and formed into a uniform film using a spin coater. It was heated at 100°C for 1 hour to obtain a self-supporting film. It was heated at 200°C for 30 minutes, 300°C for 30 minutes, and 400°C for 5 minutes to obtain a polyimide film. The peel strength of the polyimide film was measured; the result is shown in Table 1.

### Example 2

In a 300-ml separatory flask provided with DC stirrer, 3,3'-dicarboxy-4,4'-diaminobiphenyl at 2.63 g (9.7 mmol), 4,4'-diaminodiphenyl ether at 17.56 g (87 mmol), and N,N'-dimethyl acetamide at 148.88 g were put and stirred in a nitrogen atmosphere at room temperature. Furthermore, pyromellitic dianhydride at 20.41 g (94 mmol) was divided and added several times over 30 minutes to 1 hour. After stirring for 1 hour, 11.15 g of an N,N'-dimethyl acetamide solution (6 wt%) of pyromellitic dianhydride was dropped over 30 minutes and further stirred for 1 hour.

A polyimide film was obtained from the polyamic acid thus obtained by the same method as in Example 1. The peel strength of the polyimide film was measured; the result is shown in Table 1.

### Example 3

In a 300-ml separatory flask provided with DC stirrer, 3,3'-dicarboxy-4,4'-diaminobiphenyl at 5.17 g (19 mmol), 4,4'-diaminodiphenyl ether at 15.35 g (76 mmol), and N,N'-dimethyl acetamide at 149.05 g were put and stirred in a nitrogen atmosphere at room temperature. Furthermore, pyromellitic dianhydride at 20.08 g (93 mmol) was divided and added several times over 30 minutes to 1 hour. After stirring for 1 hour, 10.97 g of an N,N'-dimethyl acetamide solution (6 wt%) of pyromellitic dianhydride was dropped it over 30 minutes and further stirred for 1 hour.

A polyimide film was obtained from the polyamic acid thus obtained by the same method as in Example 1. The peel strength of the polyimide film was measured; the result is shown in Table 1.

### Example 4

In a 300-ml separatory flask provided with DC stirrer, 2,6'-dicarboxy-dicarboxy-4,4'-diaminobiphenyl at 3.10 g (11.4 mmol), 4,4'-diaminodiphenyl ether at 16.76 g (83.7 mmol) and N-dimethyl-2-pyrrolidone at 149.70 g were put and stirred in a nitrogen atmosphere at 50°C. Furthermore, pyromellitic dianhydride at 20.11 g (92.2 mmol) was divided and added several times over 30 minutes to 1 hour. After stirring for 1 hour, 9.3 g of an N-methyl-2-pyrrolidone solution (5 wt%) of pyromellitic dianhydride was dropped 30 minutes and further stirred for 1 hour.

A polyimide film was thus obtained from the polyamic acid by the same method as in Example 1. The peel strength of the polyimide film was measured; the result is shown in Table 1.

### Example 5

In a 300-ml separatory flask provided with DC stirrer, 2,6'-dicarboxy-4,4'-diaminobiphenyl at 4.61 g (16.9 mmol), 4,4'-diaminodiphenyl ether at 15.46 g (77.2 mmol), and N-dimethyl-2-pyrrolidone at 149.65 g were put and stirred in a nitrogen atmosphere at 50°C. Furthermore, pyromellitic dianhydride at 19.11 g (87.7 mmol) was divided and added several times over 30 minutes to 1 hour. After stirring for 1 hour, 9.6 g of N-methyl-2-pyrrolidone solution (5 wt%) of pyromellitic dianhydride was dropped over 30 minutes and further stirred for 1 hour.

A polyimide film was obtained from the polyamic acid thus obtained by the same method as in Example 1. The peel strength of the polyimide film was measured; the result is shown in Table 1.

### Comparative Example 1

In a 300-ml separatory flask provided with DC stirrer, 4,4'-diaminodiphenyl ether at 38.48 g (190 mmol) and N,N'-dimethyl acetamide at 320.00 g were put and stirred in a nitrogen atmosphere at room temperature. Furthermore, pyromellitic dianhydride at 40.27 g (185 mmol) was divided and added several times over 30 minutes to 1 hour. After stirring for 1 hour, 22.01 g of an N,N'-dimethyl acetamide solution (6 wt%) of pyromellitic dianhydride was dropped over 30 minutes and further stirred for 1 hour.

A polyimide film was obtained from the polyamic acid thus obtained by the same method as in Example 1. The peel strength of the polyimide film was measured; the result is shown in Table 1.

**Table 1**

| | Peel strength (N/cm) |
|---|---|
| Example 1 | 10.5 |
| Example 2 | 11.0 |
| Example 3 | 11.4 |
| Example 4 | 15.6 |
| Example 5 | 23.2 |
| Comp. Example 1 | 1.9 |

As is clear from the results in Table 1, in the polyimide films of the present invention (Examples 1-5), the adhesive force is notably improved as compared with the polyimide film of Comparative Example 1.

## Claims

1. A method for the preparation of a polyamic acid, which comprises the step of:
reacting at least one aromatic diamine containing 1-100 mol percent of carboxy-4,4'-diaminobiphenyl of Formula 1 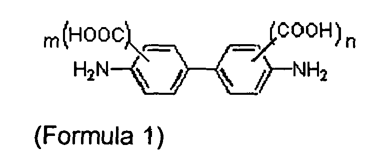
wherein m and n represent integers of 4 or less, including 0, and (m+n) is an integer of 1 or greater; and
at least one aromatic tetracarboxylic dianhydride or a derivative thereof.

2. The method according to Claim 1, wherein the at least one aromatic diamine is selected from the group consisting of: p-phenylene diamine, m-phenylene diamine, penthidine, p-xylylene diamine, 4,4'-diaminodiphenyl ether, 3,4'-diaminodiphenyl ether, 4,4'-diaminodiphenylmethane, 4,4'-diaminodiphenylsulfone, 3,3'-dimethoxypenthidine, 1,4-bis(3-methyl-5-aminophenyl) benzene, amide-forming derivatives thereof, and mixtures thereof.

3. The method according to Claim 1, wherein the carboxy-4,4'-diaminobiphenyl is 2,6'-dicarboxy-4,4'-diaminobiphenyl or 3,3'-dicarboxy-4,4'-diaminobiphenyl.

4. The method according to Claim 1, wherein the carboxy-4,4'-diaminobiphenyl is a combination of 2,6'-dicarboxy-4,4'-diaminobiphenyl and 3,3'-dicarboxy-4,4'-diaminobiphenyl.

5. The method according to any of Claims 1 to 4, wherein the at least one aromatic diamine contains 5-100 mol percent of the carboxy-4,4'-diaminobiphenyl of Formula 1.

6. The method according to any of Claims 1 to 5, wherein the at least one aromatic tetracarboxylic dianhydride is derived from an aromatic tetracarboxylic acid, said acid being selected from the group consisting of pyromellitic acid, 3,3',4,4'-biphenyltetracarboxylic acid, 2,3',4,4'-biphenyltetracarboxylic acid, 3,3',4,4'-benzophenone tetracarboxylic acid, 2,3,6,7-naphthalene dicarboxylic acid, 2,2-bis(3,4-dicarboxyphenyl) ether, pyridine-2,3,5,6-tetracarboxylic acid, amide-forming derivatives thereof, and mixtures thereof.

7. The method according to any of Claims 1 to 6, wherein the step of reacting the diamine and the dianhydride occurs in a solution comprising a solvent selected from the group consisting of sulfoxides, formamides, acetamides, pyrrolidones, phenols, aprotic polar solvents, aromatic hydrocarbons, and mixtures thereof.

8. A polyamic acid obtainable by the method of any of Claims 1 to 7.

9. A method for the preparation of a polyimide which comprises the step of imidizing the polyamic acid according to Claim 8.

10. The method according to Claim 9, wherein the polyamic acid is thermally or chemically imidized.

11. A polyimide obtainable from a polyamic acid according to the method of Claim 9, the polyimide having both the structural units of Formula 3 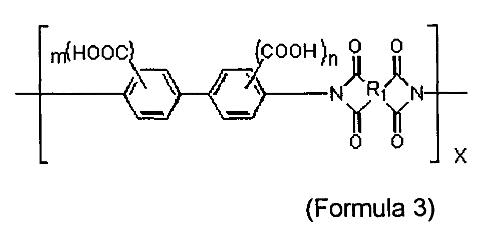 and of Formula 4 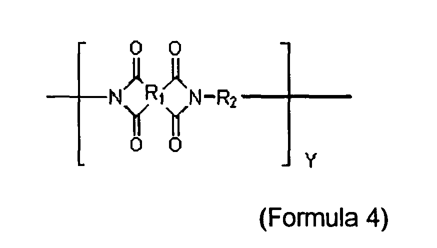 wherein R₁ represents a group expressed by the following general Formula 5, 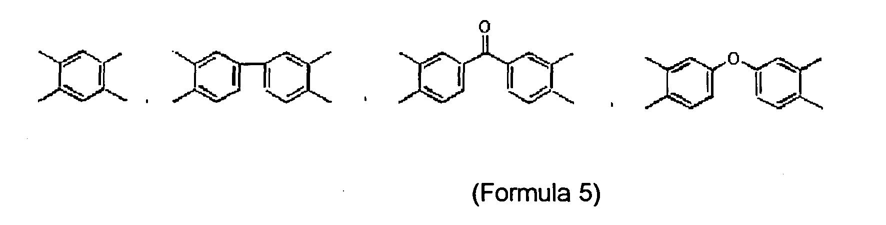 and wherein R₂ represents a group expressed by the following general formula 6, 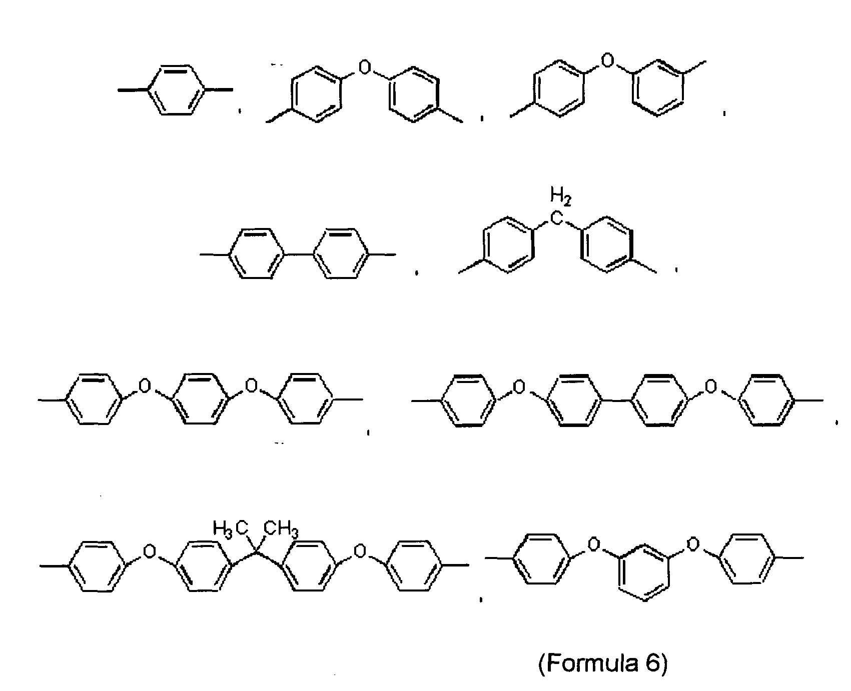 and wherein the molar ratio of X:Y is represented by the ratio of 1:99 to 100:0.

12. A polyimide film comprising the polyimide prepared according to Claim 9.

13. A polyimide film comprising the polyimide according to Claim 11.

14. A method for obtaining a polyimide film comprising the steps of:
casting a polyamic acid solution comprising a polyamic acid as defined in Claim 8 as a film; and
imidizing the polyamic acid solution to form a polyimide film.

15. The polyimide film according to Claim 12 or 13 bonded to a copper foil with an adhesive to form a laminate, the laminate having a peel strength of at least 10N/cm.
